# EUROPEAN PATENT APPLICATION

(11) **EP 4 478 615 A2**
(43) Date of publication of application: **18.12.2024**
(21) Application number: 24179603.6
(22) Date of filing: 03.06.2024
(51) Int. Cl.: H03K 17/284, H02M 1/08, H02M 1/32

(54) **GATE DRIVER AND METHOD FOR DRIVING A POWER SWITCH WITH BLANKING TIME CONTROL**

(30) Priority: 16.06.2023 DE 102023115831
(71) Applicant: Infineon Technologies Austria AG, 9500 Villach (AT)
(72) Inventor: LEE, Min Sub, 31123 Cheonan, Chungchong-namdo (KR); KANG, Kyoung Pil, 05573 Seoul (KR); LEE, Jong Uk, 10307 Goyang-si, Kyonggi-do (KR)
(74) Representative: Infineon Patent Department

(57) **Abstract**

A gate driver for driving a half-bridge is disclosed, which comprises a low voltage control logic, a high side switch control circuit and a low side switch control circuit. The low voltage control circuit generates an internal pulsed high side control signal based on a high side control signal and a common protection function blanking control signal and a low side protection function activation signal based on a low side control signal and the common protection function blanking control signal. The high side switch control circuit comprises a high side protection function circuit, which is enabled based on a first pulse of the internal pulsed high side control signal and is activated based on a second pulse of the internal high side pulsed control signal. The low side switch control comprises a low side protection function circuit, which is activated based on the protection function activation signal.

## Description

### TECHNICAL FIELD

The invention generally relates to gate drivers for power switches and more precisely to submitting timing information between different voltage domains of such gate drivers.

### BACKGROUND

While switching a power switch with a gate driver, voltage and/or current events may occur which may erroneously trigger protection functions of the gate driver, such as a desaturation detection or an overcurrent protection (OCP) function. To avoid erroneously triggering the protection functions, the gate driver may employ a blanking time, i.e. a time during which the protection functions are inhibited from detecting their respective trigger conditions. However, the blank time needs to strike a balance between the prevention of erroneous triggering, which may e.g. be caused by the blank time being too short, and belated triggering, which may e.g. be caused by the blank time being too long. For example, if the blank time is too long, the driven power switch may be damaged or destroyed.

To set the blank time, the gate driver may be configured to be coupled to passive components, allowing the blank time to be fixedly set by the dimensions of the passive components during the design stage of a control circuit incorporating the gate driver. However, this approach requires circuit area due to the size of the passive components. If the gate driver is to drive at least one phase of a three-phase inverter, the circuit area required may increase further as high-voltage isolation may be required between the passive components defining blank times for the three phases. Moreover, this approach needs to approximate all possible scenarios in which triggering should be inhibited since the blank time cannot be changed after deployment of the control circuit incorporating the gate driver. Given the many possible scenarios which may occur during switching of the power switch, which may also depend on the load coupled to the power switch, such an approximation may not be accurate.

Beside protection functions as described above, other functions provided by a gate driver may also make use of timing information. Examples of such other functions are sense functions or data transmission functions.

More general, gate drivers may include various circuitry that operates in different voltage domains. Transmitting information, such as timing information, between different voltage domains may be useful in a variety of scenarios. However, conventional solutions to this problem may require complex circuitry, have a large area consumption, or are not economically feasible.

### SUMMARY OF THE INVENTION

The present disclosure provides gate driver configured to drive a high side switch. The gate driver comprises a low-voltage control logic configured to receive a high side control signal and a timing control signal and generate an internal pulsed high side control signal based on the high side control signal and the timing control signal. The gate driver further comprises a high side switch control circuit coupled to the low-voltage control logic and configured to control the high side switch based on the internal pulsed high side control signal, which comprises a high side support function circuit, wherein the high side support function circuit is configured to be enabled based on a first pulse of the internal pulsed high side control signal and to be activated based on a second pulse of the internal pulsed high side control signal.

The present disclosure further provides a system that comprises a half-bridge arrangement comprising a high side switch and a low side switch, and a gate driver configured to driver the half-bridge arrangement. The gate driver comprises a low voltage control logic that is configured to receive a high side control signal, a low side control signal and a timing control signal, to generate an internal pulsed high side control signal based on the high side control signal and the timing control signal, and to generate a low side support function activation signal based on the low side control signal and the timing control signal. The gate driver further comprises a high side switch control circuit coupled to the low voltage control logic and coupled to a control terminal of the high side switch and configured to control the high side switch based on the internal pulsed high side control signal, the high side switch control circuit comprising a high side support function circuit, wherein the high side support function circuit is configured to be enabled based on a first pulse of the internal pulsed high side control signal and to be activated based on a second pulse of the internal pulsed high side control signal. The gate driver further comprises a low side switch control circuit coupled to the low voltage control logic and coupled to a control terminal of the low side switch and configured to control the low side switch based on the low side control signal, the low side switch control circuit comprising a low side support function circuit, wherein the low side support function circuit is configured to be activated based on the low side support function activation signal.

The present disclosure further provides a gate driver system that comprises a timing control signal input terminal configured to receive a timing control signal, a timing control signal distribution line connected to the timing control signal input terminal, and a plurality of gate drivers. Each gate driver is configured to drive a corresponding high side switch. Each gate driver of the plurality comprises low voltage control logic that is configured to receive a high side control signal and the timing control signal via the timing control signal distribution line, and to generate an internal pulsed high side control signal based on the high side control signal and the timing control signal. Each gate driver further comprises a high side switch control circuit coupled to the low voltage control logic and configured to control the corresponding high side switch based on the internal pulsed high side control signal, the high side switch control circuit comprising a high side support function circuit, wherein the high side support function circuit is configured to be enabled based on a first pulse of the internal pulsed high side control signal and to be activated based on a second pulse of the internal pulsed high side control signal.

The present disclosure further provides a method for driving a high side switch. The method comprises receiving a high side control signal and a timing control signal, generating an internal pulsed high side control signal based on the high side control signal and the timing control signal, controlling the high side switch based on the internal pulsed high side control signal, enabling a high side support function circuit based on a first pulse of the internal pulsed high side control signal, and activating the high side support function circuit based on a second pulse of the internal pulsed high side control signal.

### BRIEF DESCRIPTION OF THE DRAWINGS

Examples of the present disclosure will be described with reference to the following appended drawings, in which like reference signs refer to like elements.
FIGS. 1A to 1C illustrate a gate driver according to examples of the present disclosure.
FIGS. 2A and 2B provide examples of internal and external signals of the gate driver of Figs. 1A to 1C according to examples of the present disclosure.
FIGS. 3A and 3B provide a flowchart of a method for driving a half-bridge according to examples of the present disclosure.
FIG: 4 illustrates a gate driver system according to examples of the present disclosure.

It should be understood that the above-identified drawings are in no way intended to limit the present disclosure. Rather, these drawings are provided to assist in understanding the present disclosure. The person skilled in the art will readily understand that aspects of the present invention shown in one drawing may be combined with aspects in another drawing or may be omitted without departing from the scope of the present disclosure.

### DETAILED DESCRIPTION

The present disclosure generally provides a gate driver and a corresponding method, for controlling a high side switch based on a timing control signal in addition to a high side control signal. The timing control signal is used to control an activation time (e.g., a blanking time) of a high side support function circuit.

More precisely, an internal pulsed high side control signal is generated based on the high side control signal and the timing control signal. A first pulse of the internal pulsed high side control signal enables the high side support function circuit, i.e. renders a power supply of the high side support function circuit operable. A second pulse of the internal pulsed high side control signal activates the high side support function, i.e. causes the power supply of the high side support function circuit to provide power to the high side support function circuit. The first pulse and the second pulse of the internal pulsed high side control signal thus define the start and the end of a blanking time of the high side support function circuit. In addition, the first pulse causes the high side switch to be turned on. The high side support function circuit may implement a protection function, a sensing function, data transmission function and/or other support function that can support an efficient and safe operation of the high side switch.

The suggested gate driver and method may further be configured to drive a half-bridge comprising the high side switch and a low side switch. Here, the low voltage control logic may be configured to receive a low side control signal and generate a low side support function activation signal based on the low side control signal and the timing control signal. The gate driver further comprises a low side switch control circuit coupled to the low voltage control logic and configured to control the low side switch based on the low side control signal. The low side switch control circuit may further comprise a low side support function circuit, which is configured to be activated based on the low side support function activation signal. The low side support function activation signal causes the low side support function circuit to be activated once the blanking time has expired after the low side control signal has indicated that the low side switch is to be turned on. In addition, the low side switch is turned on directly, e.g. by forwarding the low side control signal.

The present disclosure further provides a gate driver and a corresponding method, which control a high side switch and a low side switch of a half-bridge based on a common protection function blanking control signal in addition to a low side control signal and a high side control signal. The common protection function blanking control signal is used to control a blanking time of both a high side protection function circuit and a low side protection function circuit. In other words, the common protection function blanking control signal is a reference signal defining the blanking time of both the high side protection function circuit and the low side protection function circuit.

More precisely, an internal pulsed high side control signal is generated based on the high side control signal and the common protection function blanking control signal. A first pulse of the internal pulsed high side control signal enables the high side protection function, i.e. renders a power supply of the high side protection function operable. A second pulse of the internal pulsed high side control signal activates the high side protection function, i.e. causes the power supply of the high side protection function circuit to provide power to the high side protection function circuit, thereby causing the high side protection function circuit to be operable to detect a trigger condition of the high side protection function. The first pulse and the second pulse of the internal pulsed high side control signal thus define the start and the end of the blanking time of the high side control signal. In addition, the first pulse causes the high side switch to be turned on.

Further, a low side protection function activation signal is generated based on the low side control signal and the common protection function blanking control signal. The low side protection function activation signal causes the low side protection function circuit to be activated once the blanking time has expired after the low side control signal has indicated that the low side switch is to be turned on. In addition, the low side switch is turned on directly, e.g. by forwarding the low side control signal.

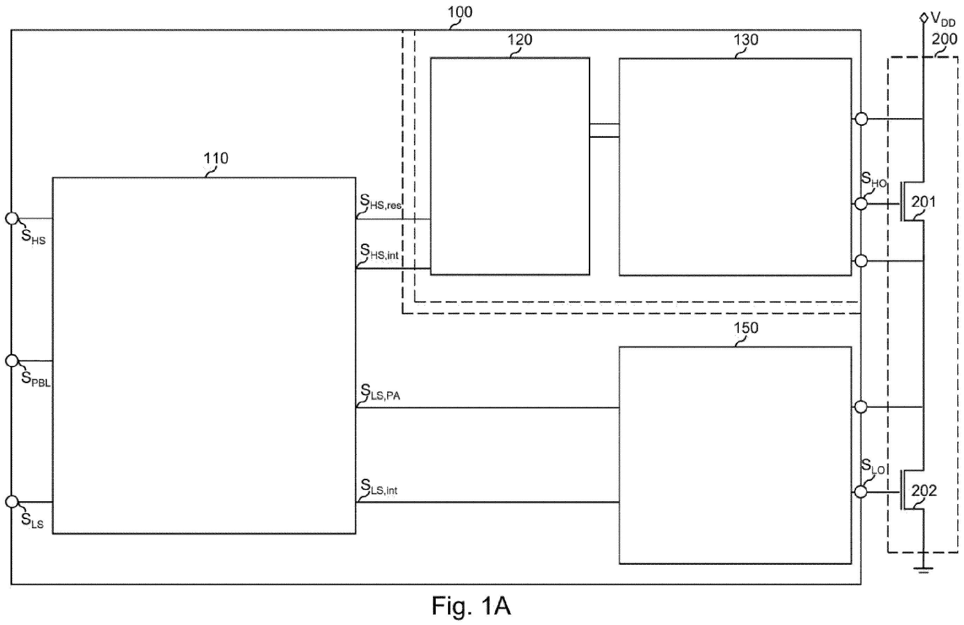

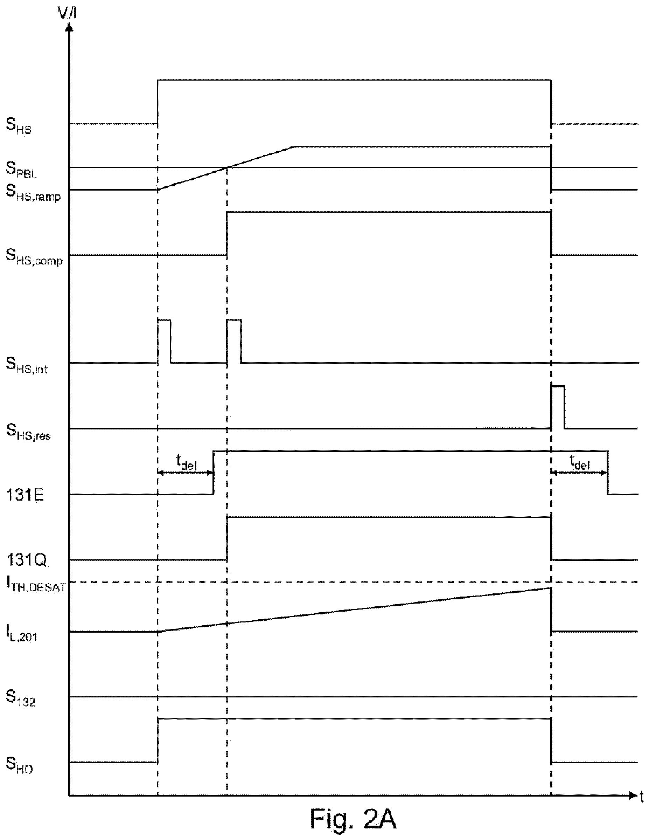

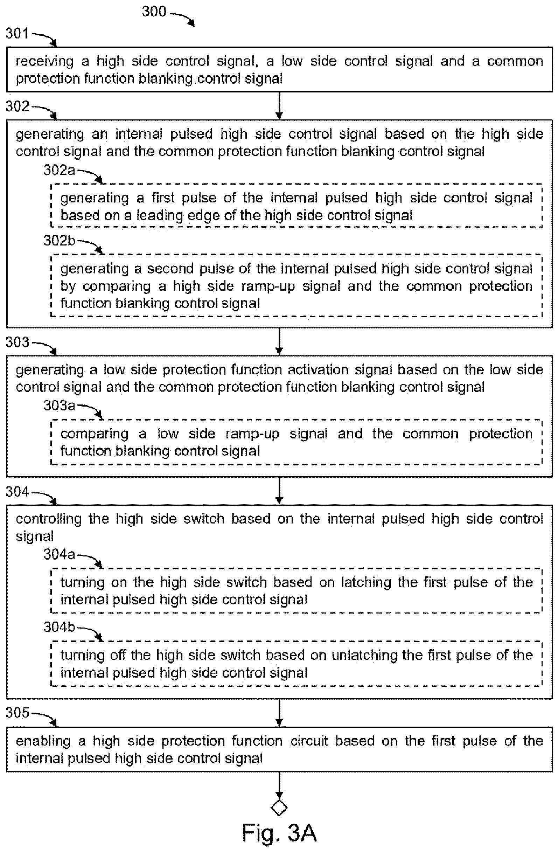

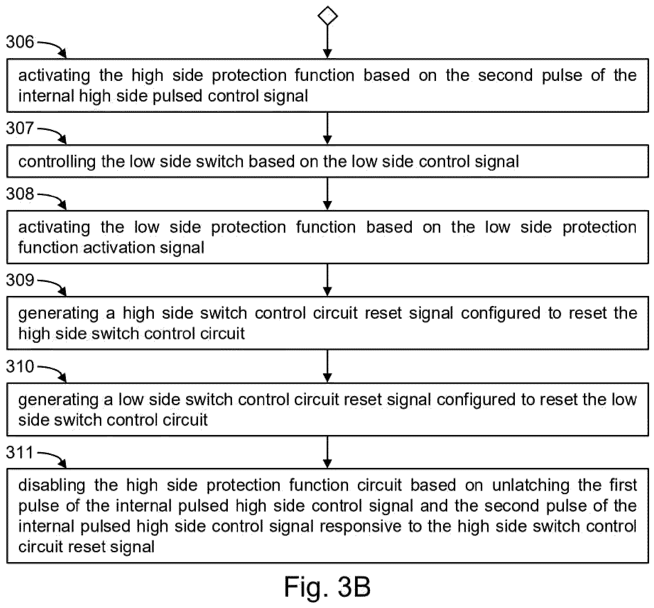

This general concept will be explained with reference to the appended drawings, with Fig. 1A to 1C illustrating examples of the gate driver and Figs. 2A to 2B providing examples of the internal and external signals of the gate driver of Figs. 1A to 1C. Further, Fig.3 illustrates the corresponding method.

In the following detailed description, the gate driver is implemented as a half-bridge gate driver by way of example. However, this should not be construed as limiting, and the gate driver may be configured as a high side driver only (e.g., without the low side switch control circuit). In addition, the support function circuit is described by way of example and without loss of generality as a protection function circuit. However, this should not be construed as limiting, and the following examples may also be practiced using a support function circuit that implements a different support function. Examples are a sensing function circuit that may be configured to sense at least one operating parameter of the controlled switch (e.g., the high side switch or low side switch), such as a voltage, current, temperature or other such parameters, or a data transmission function circuit, that may be configured to control a data transmission function, such as enabling a data transmission between the low voltage control logic and the high side switch control circuit. Furthermore, the timing control signal may be referred to as common protection function blanking control signal in the following. This is to indicate that the timing control signal may be commonly used to control a blanking time of both the high side protection function circuit and the low side protection function circuit.

FIG. 1A shows gate driver 100 coupled to a half bridge 200, which comprises a high side switch 201 and a low side switch 202 coupled between a supply voltage V_{DD}, which may, e.g., be in a range between 450 V and 1800 V, and a ground voltage.

High side switch 201 and a low side switch 202 may be any kind of power switch configured to have a high voltage blocking capability. For example, high side switch 201 and a low side switch 202 may be able to block voltages above at least 400 V, such as 450 V, 900 V, 1200 V or 1800 V. To achieve such voltage blocking capabilities, high side switch 201 and low side switch 202 may for example be a silicon or silicon carbide (SiC) metal oxide field effect transistor (MOSFET), a silicon or SiC insulated gate bipolar transistor (IGBT) or a Gallium nitride high electron mobility transistor (GaN-HEMT). It will be understood that both the voltage levels and the technology types discussed with regard to high side switch 201 and low side switch 202 are merely provided as an example.

The present disclosure may be practiced with other high voltage levels and other power switch technologies than those mentioned here.

Gate driver 100 is coupled to the control terminal of high side switch 201 and to the control terminal of low side switch 202. Further, gate driver 100 may be coupled to the first load terminal of high side switch 201 and to the first load terminal of low side switch 202, as e.g. shown in Figs. 1A to 1C, and may also be coupled to the second load terminal of high side switch 201, as e.g. shown in Figs. 1A to 1C, and to the second load terminal of low side switch 202. Whether and to which of the respective first load terminals and second load terminals gate driver 100 is coupled to may depend on the protection function or protection functions included in gate driver 100, as will be discussed in further detail below.

Gate driver 100 of Fig. 1A includes a low voltage control logic 110, a high side switch control circuit 130 and a low side switch control circuit 150. Further, gate driver 100 may include a high side signal forwarding circuit 120.

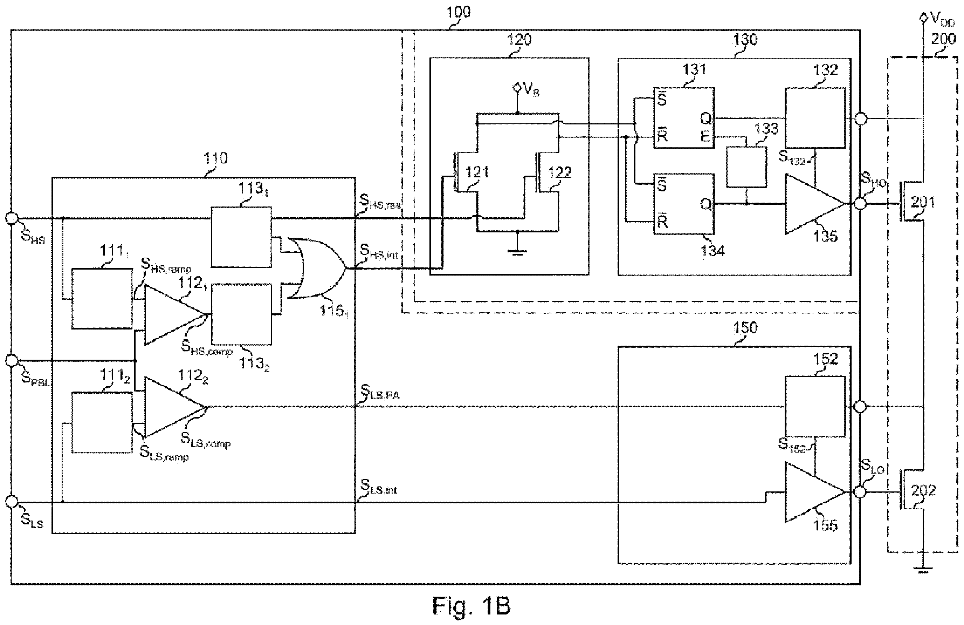

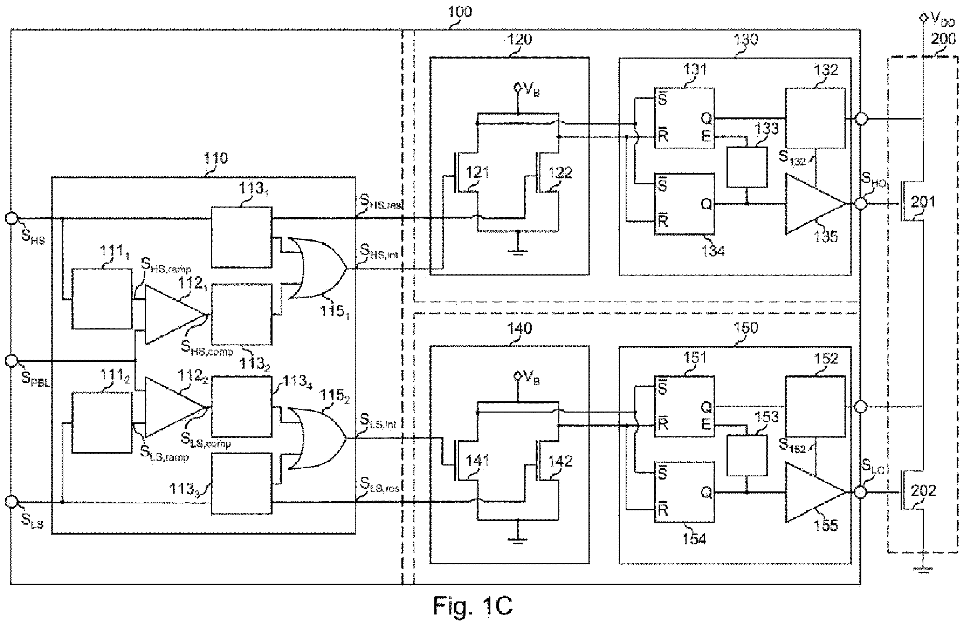

Due to the high voltage levels to be switched by half-bridge 200, gate driver 100 may in some examples of the present disclosure be separated into at least a low voltage area and a high voltage area. To this end, gate driver 100 may comprise an insulation barrier between the low voltage control logic and the high side switch control circuit, which is indicated in Figs. 1A to 1C as two adjacent dashed lines. The isolation barrier may be configured to electrically isolate the low voltage area and the high voltage area. Low voltage control logic 110 may be located in the low voltage area, while high side switch control circuit 130 may be located in the high voltage area. Accordingly, the isolation barrier may be configured to isolate low voltage control logic 110 from high side switch control circuit 130. Low side switch control circuit 150 may also be located in low the voltage area. The isolation barrier may thus be configured to isolate both low voltage control logic 110 and low side switch control circuit 150 from high side switch control circuit 130. This concept is shown in Figs. 1A and 1B. Depending on the level of isolation safety required by the environment in which gate driver 100 is to be employed, low side switch control circuit 150 may also be located in a medium voltage area separated by the isolation barrier from both the high voltage area and the low voltage area. The isolation barrier may thus be configured to isolate low voltage control logic 110, high side switch control circuit 130 and low side switch control circuit 150 from one another. This concept is illustrated in Fig. 1C by the T-shape of the isolation barrier. It will be understood that the isolation barrier need not be contiguous to provide isolation between the low voltage area, the medium voltage area and the high voltage area. Rather, the isolation barrier may also be provided as two or three separate isolation barriers depending on the actual implementation of gate driver 100.

As can be seen from the above discussion of the isolation barrier, the low voltage in the name of low voltage control logic 110 refers to the fact that low voltage control logic 110 is isolated from the high voltages to be switched by gate driver 100.

More precisely, low-voltage control logic 110 is configured to receive a high side control signal S_{HS}, a low side control signal S_{LS} and a common protection function blanking control signal S_{PBL}.

High side control signal S_{HS} indicates when high side switch 201 is to be turned on and off by gate driver 100. Low side control signal S_{LS} indicates when low side switch 202 is to be turned on and off by gate driver 100.

Common protection function blanking control signal S_{PBL} indicates the blanking time for a high side protection function and a low side protection function of gate driver 100, i.e. the time during which both the high side protection function and the low side protection function of gate driver 100 are to be inhibited. More precisely, common protection function blanking control signal S_{PBL} is a reference signal which defines the duration of the blanking time for both the high side protection function and the low side protection function of gate driver 100. In other words, common protection function blanking control signal S_{PBL} defines a common blanking time for both protection functions. In further implementations, common protection function blanking control signal is configured as a timing signal that may be used by a support function circuit of the respective gate driver that is different to the protection function circuit.

High side control signal S_{HS}, low side control signal S_{LS} and common protection function blanking control signal S_{PBL} may be provided by a microcontroller or some other logic determining when to turn on and off high side switch 201 and low side switch 202 as well as how long to inhibit the protection function of gate driver 100.

Based on the received high side control signal S_{HS} and the received common protection function blanking control signal S_{PBL}, low-voltage control logic 110 is configured to generate an internal pulsed high side control signal S_{HS,int}. Internal pulsed high side control signal S_{HS,int} is a pulsed signal, i.e. internal pulsed high side control signal S_{HS,int} conveys information based on pulses. Accordingly, internal pulsed high side control signal S_{HS,int} controls both high side switch 201 and the high side protection function of gate driver 100 based on pulses. To this end, low-voltage control logic 110 generates a first pulse of internal pulsed high side control signal S_{HS,int}. The first pulse turns on high side switch 201 and enables the protection function of gate driver 100, i.e. renders a power supply of the high side protection function circuit operable. Further, low-voltage control logic 110 generates a second pulse of internal pulsed high side control signal S_{HS,int}. The second pulse activates the high side protection function of gate driver 100, i.e. causes the power supply of the high side protection function circuit to provide power to the high side protection function circuit.

Based on the received low side control signal S_{LS} and the received common protection function blanking control signal S_{PBL}, low-voltage control logic 110 is configured to generate a low side protection function activation signal S_{LS,PA}. Low side protection function activation signal S_{LS,PA} activates a low side protection function of gate driver 100 once the blanking time as defined by common protection function blanking control signal S_{PBL} has expired.

Low-voltage control logic 110 may further be configured to generate a high side switch control circuit reset signal S_{HS,res}, which may cause high side switch control circuit 130 to be reset and to thereby turn-off high side switch 201 and the high side protection function of gate driver 100. Low-voltage control logic 110 may generate high side switch control circuit reset signal S_{HS,res} based on high side control signal S_{HS}, and more precisely based on an indication of high side control signal S_{HS} to turn off high side switch 201.

High side switch control circuit 130 is coupled to low-voltage control logic 110 and comprises the high side protection function. High side switch control circuit 130 is configured to control high side switch 201 based on internal pulsed high side control signal S_{HS,int} and more precisely based on the first pulse of on internal pulsed high side control signal S_{HS,int}. To this end, high side switch control circuit 130 provides a high side control output signal S_{HO} to the control terminal of high side switch 201. Further, as discussed above with regard to the first pulse of internal pulsed high side control signal S_{HS,int}, high side switch control circuit 130 is configured to enable the high side protection function circuit based on the first pulse of internal pulsed high side control signal S_{HS,int} and to activate the high side protection function based on the second pulse of the internal high side pulsed control signal S_{HS,int}.

Low side switch control circuit 150 is coupled to low-voltage control logic 110 and comprises the low side protection function circuit. Low side switch control circuit 150 is configured to control low side switch 202 based on low side control signal S_{LS}. To this end, low side switch control circuit 150 provides a low side control output signal S_{LO} to the control terminal of low side switch 202. Further, as discussed above with regard to the second pulse of the internal pulsed high side control signal S_{HS,int}, low side switch control circuit 150 is configured to activate the low side protection function circuit based on low side protection function activation signal S_{LS,PA}. In other words, low side protection function activation signal S_{LS,PA} may for example serve as the power supply of the low side protection function circuit or may activate a power supply of the low side protection function circuit.

In implementations of gate driver 100 including the isolation barrier, high side signal forwarding circuit 120 may be coupled between low-voltage control logic 110 and high side switch control circuit 130. Signal forwarding circuit 120 may be configured to provide internal pulsed high side control signal S_{HS,int} from low-voltage control logic 110 to high side switch control circuit 130 across the insulation barrier. In other words, signal forwarding circuit 120 forwards internal pulsed high side control signal S_{HS,int} from low-voltage control logic 110 to high side switch control circuit 130 across the isolation barrier.

Examples detailing how the above-discussed functionality of low-voltage control logic 110, high-side signal forwarding circuit 120, high side switch control circuit 130 and low side switch control circuit 150 may be implemented will now be discussed with regard to Figs. 1B and 1C.

In order to generate the first pulse of internal pulsed high side control signal S_{HS,int} based on high side control signal S_{HS}, low-voltage control logic 110 may generate the first pulse of internal pulsed high side control signal S_{HS,int} based on a leading edge of high side control signal S_{HS}. Thus, since the leading edge of high side control signal S_{HS} indicates that high side switch 201 is to be turned on, the generation of the first pulse based on the leading edge of high side control signal S_{HS} enables gate driver 100 to turn on high side switch 201 as indicated by high side control signal S_{HS}.

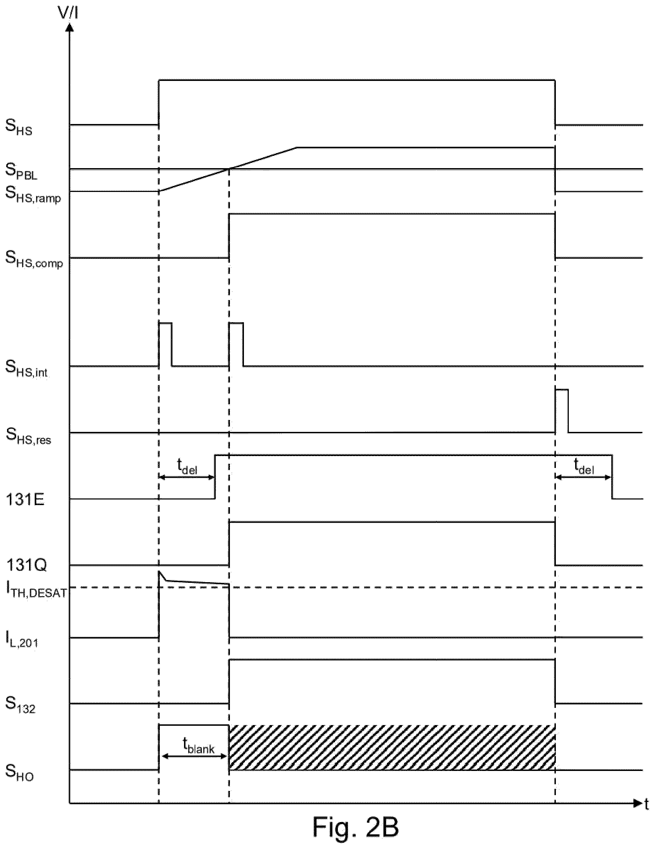

An example of the generation of the first pulse of internal pulsed high side control signal S_{HS,int} based on high side control signal S_{HS} is illustrated in Figs. 2A and 2B. Figs. 2A and 2B show that the leading edge of high side control signal S_{HS}, which is indicated in Figs. 2A and 2B by the first vertical dashed line, causes the first pulse of internal pulsed high side control signal S_{HS,int}. Further, Figs. 2A and 2B show that high side control output signal S_{HO} changes to a value causing high side switch 201 to be turned on upon the first pulse of internal pulsed high side control signal S_{HS,int}.

To generate the first pulse as discussed above, low-voltage control logic 110 may include a first high side edge triggered pulse generator 113₁. First high side edge triggered pulse generator 113₁ may be configured to generate the first pulse of internal pulsed high side control signal S_{HS,int} based on a leading edge of high side control signal S_{HS}.

First high side edge triggered pulse generator 113₁ may further be configured to generate high side switch control circuit reset signal S_{HS,res} and more precisely a pulse of high side switch control circuit reset signal S_{HS,res} based on a trailing edge of high side control signal S_{HS}. By generating high side switch control circuit reset signal S_{HS,res} based on the trailing edge of high side control signal S_{HS}, high side switch control circuit reset signal S_{HS,res} may cause high side switch control circuit 130 to turn off high side switch 201 and to deactivate the high side protection function once high side control signal S_{HS} indicates that high side switch 201 is to be turned off.

An example of an accordingly generated high side switch control circuit reset signal S_{HS,res} is for example illustrated in Fig. 2A. In Fig. 2A, the third vertical dashed line indicates the trailing edge of high side control signal S_{HS}. As can be seen, high side switch control circuit reset signal S_{HS,res} exhibits a pulse upon occurrence of the trailing edge of high side control signal S_{HS}. Accordingly, high side control signal S_{HO} changes to a value causing high side switch 201 to be turned off.

In order to generate the second pulse of internal pulsed high side control signal S_{HS,int} based on high side control signal S_{HS} and common protection function blanking control signal S_{PBL}, low-voltage control logic 110 may generate the second pulse of internal pulsed high side control signal S_{HS,int} by comparing a high side ramp-up signal S_{HS,ramp} and common protection function blanking control signal S_{PBL}.

High side ramp-up signal S_{HS,ramp} may have a non-zero signal slope upon reception of the leading edge of high side control signal S_{HS}. In the context of the present disclosure, non-zero signal slope refers to a slope which causes the value of high side ramp-up signal S_{HS,ramp} to change with a constant rate from an initial value to a final value. The initial value may be zero. The final value may be a positive value or a negative value, depending on whether low-voltage logic 110 is implemented in positive logic, i.e. logic which indicates logic "1" with a positive value, or in negative logic, i.e. logic which indicates logic "1" with a negative value. Accordingly, the non-zero slope may be a positive slope or a negative slope, depending on the type of logic used by low-voltage logic 110. Based on the non-zero slope, high side ramp-up signal S_{HS,ramp} increases in value following the leading edge of high side control signal S_{HS}.

Low-voltage control logic 110 may compare high side ramp-up signal S_{HS,ramp} to the reference value provided by common protection function blanking control signal S_{PBL}. Since high side ramp-up signal S_{HS,ramp} continues to increase in value following the leading edge of high side control signal S_{HS}, the value of high side ramp-up signal S_{HS,ramp} may eventually exceed the reference value provided by common protection function blanking control signal S_{PBL}. Once the value of high side ramp-up signal S_{HS,ramp} exceeds the reference value provided by common protection function blanking control signal S_{PBL}, low-voltage control logic 110 may generate the second pulse of internal pulsed high side control signal S_{HS,int}.

An example of the generation of the second pulse of internal pulsed high side control signal S_{HS,int} based on high side control signal S_{HS} and common protection function blanking control signal S_{PBL} is illustrated in Figs. 2A and 2B. As discussed above, the leading edge of high side control signal S_{HS} is indicated in Figs. 2A and 2B by the first vertical dashed line. Accordingly, high side ramp-up signal S_{HS,ramp} in Figs. 2A and 2B starts to increase in value from the intersection of the first vertical dashed line and high side ramp-up signal S_{HS,ramp}.

By using common protection function blanking control signal S_{PBL} as a reference value and comparing it with leading-edge triggered high side ramp-up signal S_{HS,ramp}, the time between the first pulse and the second pulse of internal pulsed high side control signal S_{HS,int} can be controlled based on the value of common protection function blanking control signal S_{PBL}. If the value of common protection function blanking control signal S_{PBL} is chosen to be close to the initial value of high side ramp-up signal S_{HS,ramp}, high side ramp-up signal S_{HS,ramp} exceeds the value of common protection function blanking control signal S_{PBL} earlier. If the value of common protection function blanking control signal S_{PBL} is chosen to be close to the final value of high side ramp-up signal S_{HS,ramp}, high side ramp-up signal S_{HS,ramp} exceeds the value of common protection function blanking control signal S_{PBL} later. Accordingly, the point in time at which high side ramp-up signal S_{HS,ramp} exceeds the value of common protection function blanking control signal S_{PBL} can be controlled based on the value of common protection function blanking control signal S_{PBL}, which in turn determines the point in time at which the second pulse of internal pulsed high side control signal S_{HS,int} is generated. In other words, the reference value provided by the common protection function blanking control signal S_{PB} determines the point in time at which the second pulse of internal pulsed high side control signal S_{HS,int} is generated, which determines the duration of the blanking time.

To generate the second pulse of internal pulsed high side control signal S_{HS,int} based on high side control signal S_{HS} and common protection function blanking control signal S_{PBL} as discussed above, low-voltage control logic 110 may include a high side protection function activation signal circuit. The high side protection function activation signal circuit may comprise a high side leading edge triggered ramp-up circuit 111₁, a high side ramp-up signal comparator 112₁ and a second high side edge triggered pulse generator 113₂. High side leading edge triggered ramp-up circuit 111₁ may be configured to provide high side ramp-up signal S_{HS,ramp} responsive to the leading edge of high side control signal S_{HS}. High side ramp-up signal comparator 112₁ may be configured to compare high side ramp-up signal S_{HS,ramp} with the common protection function blanking control signal S_{PBL}. Based on the comparison, high side ramp-up signal comparator 112₁ may be configured to output a high side comparison signal S_{HS,comp}. As e.g. illustrated in Figs. 2A and 2B, high side comparison signal S_{HS,comp} indicates whether high side ramp-up signal S_{HS,ramp} exceeds the reference value provided by common protection function blanking control signal S_{PBL}. More precisely, a leading edge of high side comparison signal S_{HS,comp} indicates the point in time at which high side ramp-up signal S_{HS,ramp} exceeds the reference value provided by common protection function blanking control signal S_{PBL} and thus the end of the blanking time. Accordingly, second high side edge triggered pulse generator 113₂ may be configured to generate the second pulse of internal pulsed high side control signal S_{HS,int} based on the leading edge of high side comparison signal S_{HS,comp}.

In order to provide both the output of first high side edge triggered pulse generator 113₁ and of second high side edge triggered pulse generator 113₂ as a single output of low-voltage control logic 110 and thus as the first pulse and the second pulse of internal pulsed high side control signal S_{HS,int}, low-voltage control logic 110 may include a high side OR gate 115₁. High side OR gate 115₁ may have two inputs respectively coupled to both high side edge triggered pulse generator 113₁ and second high side edge triggered pulse generator 113₂. Consequently, high side OR gate 115₁ may output both pulses as internal pulsed high side control signal S_{HS,int}.

In order to generate low side protection function activation signal S_{LS,PA} based on low side control signal S_{LS} and common protection function blanking control signal S_{PBL} as discussed above, low voltage control logic 110 may compare a low side ramp-up signal S_{LS,ramp} and common protection function blanking control signal S_{PBL}. Low side ramp-up signal S_{LS,ramp} has a non-zero signal slope upon reception of a leading edge of low side control signal S_{LS}. Accordingly, once a value of low side ramp-up signal S_{LS,ramp} has exceeded the reference value provided by common protection function blanking control signal S_{PBL}, low side protection function activation signal S_{LS,PA} indicates that the low side protection function is to be activated. In other words, low side protection function activation signal S_{LS,PA} may be generated analogously to the generation of the second pulse of internal pulsed high side control signal S_{HS,int} with second high side edge triggered pulse generator 113₂ omitted. More precisely, low side protection function activation signal S_{LS,PA} may thus be generated in the same manner as high side comparison signal S_{HS,comp} and may therefore also be referred to as low side comparison signal S_{LS,comp}. This fact is illustrated in Fig. 1B by the signal line carrying low side comparison signal S_{LS,comp} being designated as carrying low side protection function activation signal S_{LS,PA} outside of low voltage control logic 110.

Accordingly, low voltage control logic 110 may include a low side protection function activation signal circuit configured to generate low side protection function activation signal S_{LS,PA} as discussed above. To this end, low side protection function activation signal circuit may comprise a low side leading edge triggered ramp-up circuit 111₂ and a low side ramp-up signal comparator 112₂. Low side leading edge triggered ramp-up circuit 111₂ may be configured to provide low side ramp-up signal S_{LS,ramp} responsive to the leading edge of low side control signal S_{LS}. Low side ramp-up signal comparator 112₂ may be configured to compare low side ramp-up signal S_{LS,ramp} with common protection function blanking control signal S_{PBL} and to output low side protection function activation signal S_{LS,PA} based on the comparison.

With regard to low side control signal S_{LS}, low voltage control logic 110 of the example of Fig. 1B may be configured to forward low side control signal S_{LS} to the control terminal of low side switch 202 via low side switch control circuit 150 as internal pulsed low side control signal S_{LS,int}.

Fig. 1B illustrates the generation of low side protection function activation signal S_{LS,PA} and the processing of low side control signal S_{LS} in a different manner than the generation of internal pulsed high side control signal S_{HS,int} due to the fact that no isolation barrier is provided between low voltage control logic 110 and low side switch control circuit 150 in gate driver 100 of Fig. 1B. In examples of gate driver 100 of the present disclosure providing an isolation barrier also between low voltage control logic 110 and low side switch control circuit 150, low voltage control logic may generate low side protection function activation signal S_{LS,PA} analogously to internal pulsed high side control signal S_{HS,int}. In such examples of gate driver 100 of the present disclosure, low side protection function activation signal S_{LS,PA} may accordingly also be referred to as internal pulsed low side control signal S_{LS,int}, which may have a first pulse and a second pulse analogously to the first pulse and the second pulse of internal pulsed high side control signal S_{HS,int}. Further, in such examples of gate driver 100, low voltage control logic 110 may generate a low side switch control circuit reset signal S_{LS,res} analogously to the generation of high side switch control circuit reset signal S_{HS,res}. Such an example of gate driver 100 is shown in Fig. 1C.

In addition to the elements of low voltage control logic 110 already discussed with regard to Fig. 1B, low voltage control logic 110 of Fig. 1C further comprises first low side edge triggered pulse generator 113₃, second low side edge triggered pulse generator 113₄ and low side OR gate 115₂, which respectively correspond to first high side edge triggered pulse generator 113₁, second high side edge triggered pulse generator 113₂ and high side OR gate 115₁. Second low side edge triggered pulse generator 113₄ may thus be included in the low side protection function activation signal circuit.

In the example of Figs. 1A and 1B, high side signal forwarding circuit 120 is implemented with a level shifter comprising a high side set transistor 121 and a high side reset transistor 122. High side set transistor 121 receives internal pulsed high side control signal S_{HS,int} at the control terminal of high side set transistor 121 and thereby couples a voltage source V_{B} to high side switch control circuit 130. Accordingly, high side set transistor 121 shifts internal pulsed high side control signal S_{HS,int} to the voltage level of voltage source V_{B} and isolates low voltage control logic 110 from high side switch control circuit 130 based on the isolation of high side set transistor 121 between the control terminal and the load path of high side set transistor 121. Likewise, high side reset transistor 122 receives high side switch control circuit reset signal S_{HS,res} at the control terminal of high side reset transistor 122 and shifts high side switch control circuit reset signal S_{HS,res} to the voltage level of voltage source V_{B} while isolating low voltage control circuit 110 from high side switch control circuit 130.

It will be understood that the implementation of high side signal forwarding circuit 120 as a level shift circuit in Figs. 1B and 1C is merely provided as an example. High side signal forwarding circuit 120 may also be implemented as a coreless transformer, an optocoupler, a solid state relay or any other type of circuitry capable of transmitting internal pulsed high side control signal S_{HS,int} and high side switch control circuit reset signal S_{HS,res} across the isolation barrier while ensuring isolation of low voltage control logic 110 from high side switch control circuit 130.

If the isolation barrier is also present between low voltage control logic 110 and low side switch control circuit 150, gate driver 100 may also include a low side signal forwarding circuit 140, as shown in Fig. 1C. Low side signal forwarding circuit 140 in the example of Fig. 1C is implemented in the same manner as high side signal forwarding circuit 120, i.e. as a level shift circuit comprising a low side set transistor 141 receiving internal pulsed low side control signal S_{LS,int} at the control terminal of low side set transistor 141 and a low side reset transistor 142 receiving low side switch control circuit reset signal S_{LS,res} at the control terminal of low side reset transistor 142. Like high side switch control circuit 140, low side switch control circuit 150 may be implemented by any type of circuitry capable of forwarding internal pulsed low side control signal S_{LS,int} and low side switch control circuit reset signal S_{LS,res} across the isolation barrier while ensuring isolation of low voltage logic 110 from low side switch control circuit 150.

As discussed above with regard to Fig. 1A, high side switch control circuit 130 is configured to turn on high side switch 201 and to enable the high side protection function based on the first pulse of internal pulsed high side control signal S_{HS,int} and to activate the high side protection function based on the second pulse of internal pulsed high side control signal S_{HS,int}. To this end, high side switch control circuit 130 may be configured to latch the first pulse of internal pulsed high side control signal S_{HS,int} and to latch the second pulse of internal pulsed high side control signal S_{HS,int}. Further, if the first pulse and the second pulse of internal pulsed high side control signal S_{HS,int} are latched, high side switch control circuit 130 may further be configured to unlatch the first pulse and the second pulse to turn-off high side switch 201 and disable the high side protection function circuit responsive to the high side switch control circuit reset signal.

To latch and unlatch, respectively, the first pulse and the second pulse of internal pulsed high side control signal S_{HS,int}, high side switch control circuit 130 may in some examples of the present disclosure include a high side protection function flip-flop 131 and a high side switch control flip-flop 134. In addition, high side switch control circuit 130 may include a high side protection function circuit 132, a high side delay block 133 and a high side driver stage 135.

High side switch control flip-flop 134 may have a set input, a reset input and an output. The set input of high side switch control flip-flop 134 may be configured to receive internal pulsed high side control signal S_{HS,int}. The reset input of high side switch control flip-flop 134 may be configured to receive high side switch control circuit reset signal S_{HS,res}. The output of high side switch control flip-flop 134 may be coupled to the control terminal of high side switch 201. Thus, as long as high side switch control flip-flop 134 latches the first pulse of internal pulsed high side control signal S_{HS,int}, the output of high side switch control flip-flop 134 causes high side switch 201 to stay turned on.

High side protection function flip-flop 131 may have a set input, a reset input, an enable input and an output coupled to high side protection function circuit 132. The set input of high side protection function flip-flop 131 may be configured to receive internal pulsed high side control signal S_{HS,int}. The reset input of high side protection function flip-flop 131 may be configured to receive high side switch control circuit reset signal S_{HS,res}. The enable input of high side protection function flip-flop 131 may be configured to receive the output of high side switch control flip-flop 134. Accordingly, high side protection function flip-flop 131 may be configured to be enabled based on the first pulse of internal pulsed high side control signal S_{HS,int}. This is due to the fact that the output of high side switch control flip-flop 134 may provide a signal enabling high side protection function flip-flop 131 only once high side switch control flip-flop 134 has latched the first pulse of internal pulsed high side control signal S_{HS,int}. Since high side protection function flip-flop 131 is enabled by the first pulse of internal pulsed high side control signal S_{HS,int}, high side protection function flip-flop 131 can only latch the second pulse of internal pulsed high side control signal S_{HS,int} given that high side protection function flip-flop 131 is not enabled when it receives the first pulse of internal pulsed high side control signal S_{HS,int} at the set input. Once high side protection function flip-flop 131 has latched the second pulse of internal pulsed high side control signal S_{HS,int}, high side protection function flip-flop 131 provides a signal value at the output causing high side protection function circuit 132 to be activated. In other words, high side protection function flip-flop 131 may be considered the power supply of high side protection function circuit 132, which is enabled by the first pulse of internal pulsed high side control signal S_{HS,int}. and activated based on the second pulse of internal pulsed high side control signal S_{HS,int}.

To further ensure that high side protection function flip-flop 131 only latches the second pulse of internal pulsed high side control signal S_{HS,int}, high side delay block 133 may be coupled between the output of high side switch control flip-flop 134 and the enable input of high side protection function flip-flop 131. High side delay block 133 may delay the provision of transitions of the signal provided at the output of high side switch control flip-flop 134. Accordingly, high side delay block 133 may delay enabling high side protection function flip-flop 131 based on latching the first pulse of internal pulsed high side control signal S_{HS,int}.

High side protection function circuit 132 may be configured to detect a desaturation of high side switch 201 and to turn off high side switch based on the detected desaturation. To this end, high side protection function circuit 132 may be coupled to the first load terminal of high side switch 201 in order to monitor load current I_{L,201} of high side switch 201. Further, high side protection function circuit 132 may be coupled to high side driver stage 135. Once high side protection function circuit 132 detects that load current I_{L,201} of high side switch 201 exceeds a desaturation threshold I_{TH,DESAT}, high side protection function circuit 132 provides a high side disable signal S₁₃₂ to high side driver stage 135 in order to disable high side driver stage 135 and to turn off high side switch 201 regardless of internal pulsed high side control signal S_{HS,int} and thus regardless of high side control signal S_{HS}.

It will be understood that high side protection function circuit 132 may be any kind of protection function configured to detect a failure condition of high side power switch 201. Accordingly, high side protection function circuit 132 is merely described as a desaturation detection as an example. Gate driver 100 may employ any kind of protection function suitable to protect high side switch 201.Further, it will be understood that gate driver 100 may in some examples of the present disclosure include more than one high side protection function circuit 132, which may all be controlled based on the blank time defined by common protection function blanking control signal S_{PBL}.

High side driver stage 135 may be coupled between high side switch control flip-flop 134 and the control terminal of high side switch 201. Responsive to the latched first pulse of internal pulsed high side control signal S_{HS,int}, high side driver stage 135 may provide high side control output signal SHO to the control terminal of high side switch 201 at a value causing high side switch 201 to be turned on and to stay turned on as long as high side switch control flip-flop 134 provides the latched second pulse of internal pulsed high side control signal S_{HS,int} to high side driver stage 135 unless the latched second pulse of internal pulsed high side control signal S_{HS,int} is overridden by high side disable signal S₁₃₂.

Figs. 2A and 2B provide an example of the various signals discussed above with regard to the exemplary functionality of high side switch control circuit 130. More precisely, Figs. 2A and 2B illustrate the signal provided at the enable input of high side protection function flip-flop 131, i.e. enable signal 13 1E, the signal provided at the output of high side protection function flip-flop 131, i.e. activation signal 131Q, high side switch load current I_{L,201}high side disable signal S₁₃₂ and high side control output signal S_{HO}.

Enable signal 131E in both Figs. 2A and 2B is delayed with respect to the first pulse of internal pulsed high side control signal S_{HS,int} by a delay time t_{del} defined by high side delay block 133. Since signal 131E is based on the first pulse of internal pulsed high side control signal S_{HS,int} latched by high side switch control flip-flop 134, enable signal 13 1E stays at a value enabling high side protection function flip-flop 131 until high side switch control flip-flop 134 is reset by high side switch control circuit reset signal S_{HS,res}. The reset may also be delayed by high side delay block 133, as illustrated by the third dashed line and delay time t_{del} in Figs. 2A and 2B.

Activation signal 131Q as the output signal of high side protection function flip-flop 131 corresponds to the latched second pulse of internal pulsed high side control signal S_{HS,int}. As such, activation signal 131Q exhibits a value causing high side protection function circuit 132 to be activated upon occurrence of the second pulse of internal pulsed high side control signal S_{HS,int}, as illustrated by the second dashed line in both Figs. 2A and 2B. Activation signal 131Q stays at this value until high side protection function flip-flop 131 is reset by high side switch control circuit reset signal S_{HS,res}.

Once activation signal 131Q exhibits the value causing high side protection function circuit 132 to be activated, high side protection function 132 may detect a desaturation of high side switch 201. Accordingly, high side protection function circuit 132 starts monitoring high side switch load current I_{L,201}. In Fig. 2A, high side switch load current I_{L,201} starts to increase slowly upon turn-on of high side switch 201 but never reaches desaturation threshold I_{TH,DESAT} until high side control signal S_{HS} indicates that high side switch 201 is to be turned off. Accordingly, high side disable signal S₁₃₂ in Fig. 2A does not indicate to high side driver stage 135 that high side switch 201 is to be turned off. High side switch 201 is thus only tuned off once high side control signal S_{HS} indicates that high side switch 201 is to be turned off.

In Fig. 2B, high side switch load current I_{L,201} immediately exceeds desaturation threshold I_{TH,DESAT} upon turn-on of high side switch 201. However, to avoid erroneous turn-off during switching of high side switch 201, high side disable signal S₁₃₂ does not indicate to high side driver stage 135 that high side switch 201 is to be turned off until blanking time t_{blank} has expired. Upon expiry of blank time t_{blank}, high side switch load current I_{L,201} in Fig. 2B still exceeds desaturation threshold I_{TH,DESAT}. Accordingly, since high side protection function circuit 132 is activated upon expiry of blank time t_{blank}, high side protection function circuit 132 outputs high side disable signal S₁₃₂ at a value indicating to high side driver stage 135 that high side switch 201 is to be turned off regardless of the latched first pulse of internal pulsed high side control signal S_{HS,int}. This is illustrated by the shaded area of high side control output signal S_{HO}, in which high side control output signal S_{HO} has a value causing high side switch 201 to be turned off despite high side control signal S_{HS} indicating that high side switch 201 should be turned on.

In summary, Fig. 2A illustrates an example of the signals of gate driver 100 in which high side protection function circuit 132 does not detect a desaturation event of high side switch 201 after expiry of blanking time t_{blank} as defined by common protection function blanking control signal S_{PBL}. Fig. 2B illustrates an example of the signals of gate driver 100 in which high side protection function circuit 132 detects a desaturation event of high side switch 201 after expiry of blanking time t_{blank} as defined by common protection function blanking control signal S_{PBL}.

Depending on the isolation requirements between low voltage control logic 110 and low side switch control circuit 150 may for example be implemented as shown in Fig. 1B or as shown in Fig. 1C. In Fig. 1B, low side switch control circuit 150 may include low side protection function circuit 152 and low side driver stage 155, which respectively correspond to high side protection function 132 and high side driver stage 135. Low side protection function circuit 152 may be activated based on low side protection function activation signal S_{LS,PA} and may deactivate low side driver stage 155 by generating low side disable signal S₁₅₂ if low side protection function circuit 152 detects a desaturation of low side transistor 202. In Fig. 1C, low side switch control circuit 150 may additionally include low side protection function flip-flop 151, low side delay block 153 and low side switch control flip-flop 154, which respectively correspond to high side protection function flip-flop 131, high side delay block 133 and high side switch control flip-flop 134. In other words, low side switch control circuit 150 of Fig. 1C is configured to activate low side protection function circuit 152 and to control low side switch 202 based on latching the first pulse and the second pulse of internal pulsed low side control signal S_{LS,int} analogously to high side switch control circuit 130 and internal pulsed high side control signal S_{HS,int} discussed above.

While the example signals of Figs. 2A and 2B relate to high side switch control circuit 130, It will be understood that these examples are likewise applicable to the corresponding signals of low side switch control circuit 150.

It should be noted that the preceding discussion of exemplary implementations of high side switch control circuit 130 and low side switch control circuit 150 is merely provided as an example of a control of high side switch 201 and low side switch 202 based on the internal pulsed high side control signal S_{HS,int}, low side protection function activation signal S_{LS,PA} and common protection function blanking signal S_{PBL}. High side switch control circuit 130 and low side switch control circuit 150 may be implemented in any way capable of controlling half bridge 200 based on high side control signal S_{HS} and low side control signal S_{LS} and activating their respective protection functions after expiry of the blanking time t_{blank} as defined by the reference value of common protection function blanking control signal S_{PBL}. For example, the functionality of high side switch control circuit 130 need not be based on the concept of latching the pulses of internal pulsed high side control signal S_{HS,int} but may employ other means of maintaining the values associated with the pulses in order to control high side switch 201 as well as activate and enable protection function circuit 132 until instructed to turn off high side switch 201 and deactivate high side protection function circuit 132 by high side control signal S_{HS}.

Figs. 3A and 3B illustrate a method 300 for driving half-bridge 200, which may be employed by gate driver 100 of Figs. 1A to 1C.

In step 301, method 300 receives high side control signal S_{HS}, low side control signal S_{LS} and common protection function blanking control signal S_{PBL}.

In step 302, method 300 generates internal pulsed high side control signal S_{HS,int} based on high side control signal S_{HS} and common protection function blanking control signal S_{PBL}. Step 302 may include a step 302a, in which method 300 may generate a first pulse of internal pulsed high side control signal S_{HS,int} based on a leading edge of high side control signal S_{HS}. Step 302 may further include a step 302b, in which method 300 may generate a second pulse of internal pulsed high side control signal S_{HS,int} by comparing high side ramp-up signal S_{HS,ramp} and common protection function blanking control signal S_{PBL}.

In step 303, method 300 generates low side protection function activation signal S_{LS,PA} based on low side control signal S_{LS} and common protection function blanking control signal S_{PBL}. Step 303 may include a step 303a, in which method 300 may compare low side ramp-up signal S_{LS,ramp} and common protection function blanking control signal S_{PBL}.

In step 304, method 300 controls high side switch 201 based on internal pulsed high side control signal S_{HS,int}. Step 304 may include a step 304a, in which method 300 may turn on high side switch 201 based on latching the first pulse of internal pulsed high side control signal S_{HS,int}. Step 304 may further include a step 304b, in which method 300 may turn off high side switch 201 based on unlatching the first pulse of internal pulsed high side control signal S_{HS,int}.

In step 305, method 300 enables high side protection function circuit 132 based on the first pulse of internal pulsed high side control signal S_{HS,int}. Enabling high side protection function circuit 132 in step 305 may further be based on latching the first pulse of internal pulsed high side control signal S_{HS,int}.

In step 306, method 300 activates high side protection function circuit 132 based on the second pulse of internal high side pulsed control signal S_{HS,int}. Activating high side protection function circuit 132 in step 306 may further be based on latching the second pulse of internal pulsed high side control signal S_{HS,int}.

In step 307, method 300 controls low side switch 202 based on low side control signal S_{LS}.

In step 308, method 300 activates low side protection function circuit 152 based on low side protection function activation signal S_{LS,PA}. It should be noted that, method 300 may also disable low side protection function circuit 152 based on low side protection function activation signal S_{LS,PA}.

In step 309, method 300 may generate high side switch control circuit reset signal S_{HS,res}, which may be configured to reset the high side switch control circuit.

In step 310, method 300 may generate low side switch control circuit reset signal S_{LS,res}, which may be configured to reset the low side switch control circuit.

In step 311, method 300 may disable high side protection function circuit 132 based on unlatching the first pulse of internal pulsed high side control signal S_{HS,int} and the second pulse of the internal pulsed high side control signal S_{HS,int} responsive to high side switch control circuit reset signal S_{HS,res}.

It will be understood that the steps of method 300 defining the latching and unlatching of the first pulse and the second pulse of internal pulsed high side control signal S_{HS,int} may also be performed by method 300 in examples of the present disclosure in which low side protection function activation signal S_{LS,PA} is implemented as internal pulsed low side control signal S_{LS}, int.

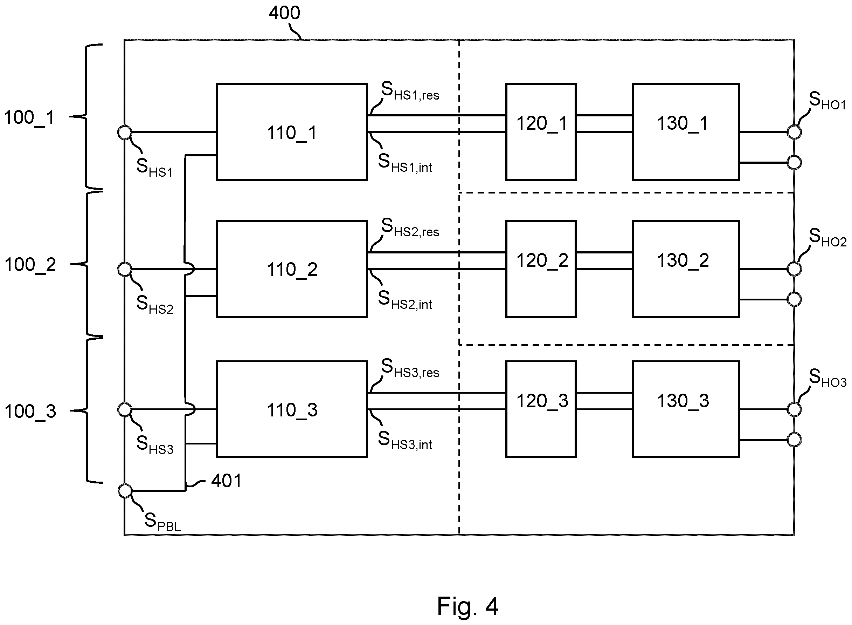

Fig. 4 illustrates a gate driver system 400 with a plurality of gate drivers 100_1, 100_2, 100_3. In this example, three gate drivers are shown, but the disclosure is not limited to this number. Further, by way of example, the three gate drivers are implemented as high side drivers. In further implementations, one or more low side gate drivers may be present in the gate driver system 400. Each one of the gate drivers 100_1, 100_2, 100_3 may be implemented in a way as described referring to one of Figs. 1A-1C.

Furthermore, in this example, the three gate drivers 100_1, 100_2, 100_3 are integrated on a single chip having one low voltage region and a high voltage region corresponding to each gate driver. In alternative implementations, the gate drivers may be integrated on different chips. In that case, the gate drivers may be integrated in a same package.

The gate driver system 400 includes a timing control signal input terminal configured to receive a timing control signal SPBL. The timing control signal input terminal is coupled to a timing control signal distribution line 401 that is configured to distributes the timing control signal SPBL to a plurality of elements. This may be particularly useful in cases where the gate drivers and/or other functional circuits are integrated on different chips in one package or arrangement, since it can help to reduce a number of external pins that may be required to provide a timing control signal to the respective circuits.

Each of the gate drivers 100_1, 100_2, 100_3 includes a corresponding low voltage control logic 110_1, 110_2, 110_3 that is respectively configured to receive a corresponding high side control signal SHS1, SHS2, SHS3 and the timing control signal SPBL via a timing control signal distribution line 401 that is part of the gate driver system 400. Each respective low voltage control logic 110_1, 110_2, 110_3 is further configured to generate a respective internal pulsed high side control signal SHS1,int, SHS2,int, SHS3,int based on the respective high side control signal SHS1, SHS2, SHS3 and the timing control signal SPBL. In addition, each of the gate drivers 100_1, 100_2, 100_3 includes a corresponding high side switch control circuit 130_1, 130_2, 130_3 coupled to the corresponding low voltage control logic 110_1, 110_2, 110_3 and configured to control the corresponding high side switch (not shown in Fig. 4) via the corresponding drive signal output SHO1, SHO2, SHO3 based on the respective internal pulsed high side control signal SHS1,int, SHS2,int, SHS3,int. Each high side switch control circuit 130_1, 130_2, 130_3 comprises a respective high side support function circuit (not shown in Fig. 4), which is configured to be enabled based on a respective first pulse of the internal pulsed high side control signal SHS1,int, SHS2,int, SHS3,int and to be activated based on a respective second pulse of the internal high side pulsed control signal SHS1,int, SHS2,int, SHS3,int.

Fig. 4 also shows an insulation barrier between the low voltage control logic 110_1, 110_2, 110_3 and the respective high side switch control circuit 130_1, 130_2, 130_3 that is configured to electrically isolate the low voltage control logic 110_1, 110_2, 110_3 from the respective high side switch control circuit 130_1, 130_2, 130_3. In addition, insulation barriers are provided between the different high side switch control circuits 130_1, 130_2, 130_3 of the different gate drivers as these are integrated in one chip in this example.

Each gate driver 100_1, 100_2, 100_3 further comprises a respective high side signal forwarding circuit 120_1, 120_2, 120_3 coupled between the respective low voltage control logic 110_1, 110_2, 110_3 and the corresponding high side switch control circuit 130_1, 130_2, 130_3. The respective high side signal forwarding circuit 120_1, 120_2, 120_3 is configured to provide the respective internal pulsed high side control signal SHS1,int, SHS2,int, SHS3,int from the respective low voltage control circuit 110_1, 110_2, 110_3 to the corresponding high side switch control circuit 130_1, 130_2, 130_3 across the insulation barrier.

In a further aspect, a gate driver having a first voltage domain and a second voltage domain is suggested. The first voltage domain and the second voltage domain are electrically isolated from each other. The first voltage domain and the second voltage domain may be referenced to different reference potentials. The gate driver comprises a first circuit residing in the first voltage domain, and comprises a second circuit residing in the second voltage domain. The first circuit is configured to receive a first control signal and a timing control signal, and to generate an internal pulsed control signal based on the first control signal and the timing control signal. The internal pulsed control signal may include a first pulse and a second pulse, wherein a time interval between the first pulse and the second pulse may be determined based on the timing control signal. The first circuit may comprise a signal forwarding circuit coupled between the first voltage domain and the second voltage domain and configured for transmitting the internal pulsed control signal from the first voltage domain to the second voltage domain. The second circuit is configured to receive the internal pulsed control signal and process, transmit, and/or operate based on the internal pulsed control signal. The second circuit may be configured to perform a control function based on the internal pulsed control signal, such as controlling a switching state of a transistor, controlling an operating state of a protection function and/or sensing function and/or data transmission function that is/are residing in the second voltage domain.

For example, the first voltage domain may be referenced to a common ground potential shared between the gate driver and further, external electrical devices the gate driver is electrically connected to, and the second voltage domain may be referenced to a floating node that may have a variable potential that may depend on an operating state of the gate driver and/or other external devices the gate driver is electrically connected to.

In some embodiments, the signal forwarding circuit may be one of a level shift circuit, a coreless transformer, an optocoupler and a solid state relay.

In some embodiments, a logic circuit, such as a programmable logic array (PLC), field-programmable gate array (FPGA), a microcontroller unit (MCU) or application-specific integrated circuit (ASIC) may be arranged in the first and/or second voltage domain and may be controlled, at least in part, based on the first control signal, the timing control signal and/or the internal pulsed control signal.

In some embodiments, the second circuit may be configured determine a timing information based on receiving the internal pulsed control signal. For example, the second circuit may determine a time interval between a first and a second pulse, or between further consecutive pulses, as the timing information.

In some embodiments, the second circuit may be configured to latch the timing information and perform a function based on the timing information. In further embodiments, the second circuit may perform a function based on the timing information exactly once, or a predefined number of times, or repeatedly, until a new timing information is determined from the internal pulsed control signal.

In some embodiments, the first voltage domain and the second voltage domain are galvanically isolated from each other. In further embodiments, an isolation rating of an isolation region arranged between the first voltage domain and the second voltage domain may be at least 600 V, or at least 1200 V, or at least 2000 V, and may be up to 5600 V.

In some embodiments, the first circuit may be implemented corresponding to the low-voltage control logic described herein. In some embodiments, the second circuit may be implemented corresponding to the high side switch control circuit described herein.

In some embodiments, the gate driver is monolithically integrated in a single chip. "Monolithically integrated" means, for example, that the gate driver is implemented on a single silicon (or other suitable material) substrate.

The invention may further be illustrated by the following examples.

In an example, a gate driver is configured to drive a high side switch, the gate driver comprising:
a low voltage control logic configured to:
   receive a high side control signal and a timing control signal; and
   generate an internal pulsed high side control signal based on the high side control signal and the timing control signal;
a high side switch control circuit coupled to the low voltage control logic and configured to control the high side switch based on the internal pulsed high side control signal, the high side switch control circuit comprising a high side support function circuit, wherein the high side support function circuit is configured to be enabled based on a first pulse of the internal pulsed high side control signal and to be activated based on a second pulse of the internal pulsed high side control signal.

The example gate driver, further comprising:
an insulation barrier between the low voltage control logic and the high side switch control circuit configured to electrically isolate the low voltage control logic from the high side switch control circuit; and
a high side signal forwarding circuit coupled between the low voltage control logic and the high side switch control circuit,
wherein the high side signal forwarding circuit is configured to provide the internal pulsed high side control signal from the low voltage control logic to the high side switch control circuit across the insulation barrier.

The example gate driver, wherein the signal forwarding circuit is one of a level shift circuit, a coreless transformer, an optocoupler and a solid state relay.

The example gate driver, wherein the low voltage control logic is further configured to:
generate the first pulse of the internal pulsed high side control signal based on a leading edge of the high side control signal; and
generate the second pulse of the internal pulsed high side control signal by comparing a high side ramp-up signal and the timing control signal (S_{PBL}), the high side ramp-up signal (S_{HS,ramp}) having a non-zero signal slope upon reception of the leading edge of the high side control signal.

The example gate driver, wherein the low voltage control logic comprises:
a first high side edge triggered pulse generator configured to generate the first pulse of the internal pulsed high side control signal based on the leading edge of the high side control signal; and
a high side support function activation signal circuit configured to generate the second pulse of the internal pulsed high side control signal, comprising:
   a high side leading edge triggered ramp-up circuit, the high side leading edge triggered ramp-up circuit being configured to provide the high side ramp-up signal responsive to the leading edge of the high side control signal;
   a high side ramp-up signal comparator configured to compare the high side ramp-up signal with the timing control signal and to output a high side comparison signal based on the comparison; and
   a second high side edge triggered pulse generator configured to generate the second pulse of the internal pulsed high side control signal based on a leading edge of the high side comparison signal.

The example gate driver, wherein the low voltage control logic is further configured to generate a high side switch control circuit reset signal configured to reset the high side switch control circuit.

The example gate driver, wherein the first high side edge triggered pulse generator is further configured to generate the high side switch control circuit reset signal based on a trailing edge of the high side control signal.

The example gate driver, wherein the high side switch control circuit is further configured to:
turn-on the high side switch and enable the high side support function circuit based on latching the first pulse of the internal pulsed high side control signal; and
activate the high side support function circuit based on latching the second pulse of the internal pulsed high side control signal.

The example gate driver, wherein the high side switch control circuit is further configured to:
turn-off the high side switch and disable the high side support function circuit based on unlatching the first pulse of the internal pulsed high side control signal and the second pulse of the internal pulsed high side control signal responsive to the high side switch control circuit reset signal.

The example gate driver, wherein the high side switch control circuit further comprises:
a high side switch control flip-flop having a set input and a reset input and configured to receive the internal pulsed high side control signal at the set input and to receive the high side switch control circuit reset signal at the reset input; and
a high side support function flip-flop having a set input, a reset input and an enable input and configured to receive the internal pulsed high side control signal at the set input, the high side switch control circuit reset signal at the reset input and an output of the high side switch control flip-flop at the enable input.

The example gate driver, wherein:
the high side support function circuit is configured to detect a desaturation of the high side switch and to turn off the high side switch based on the detected desaturation.

The example gate driver, further configured to drive a half-bridge comprising the high side switch and a low side switch, wherein the low voltage control logic is further configured to:
receive a low side control signal; and
generate a low side support function activation signal based on the low side control signal and the timing control signal;
and the gate driver further comprises:
a low side switch control circuit coupled to the low voltage control logic and configured to control the low side switch based on the low side control signal, the low side switch control circuit comprising a low side support function circuit, wherein the low side support function circuit is configured to be activated based on the low side support function activation signal.

The example gate driver, wherein the low voltage control logic is further configured to:
generate the low side support function activation signal by comparing a low side ramp-up signal and the timing control signal, the low side ramp-up signal having a non-zero signal slope upon reception of a leading edge of the low side control signal.

The example gate driver, wherein the low voltage control logic further comprises:
a low side support function activation signal circuit configured to generate the low side support function activation signal, comprising:
a low side leading edge triggered ramp-up circuit, the low side leading edge triggered ramp-up circuit being configured to provide the low side ramp-up signal responsive to the leading edge of the low side control signal; and
a low side ramp-up signal comparator configured to compare the low side ramp-up signal with the timing control signal and to output the low side support function activation signal based on the comparison.

The example gate driver, wherein the high side support function circuit is configured as a high side protection function circuit, and/or the low side control function circuit is configured as a low side protection function circuit, and the timing control signal is configured as a common protection function blanking control signal.

The example gate driver of any one of the preceding claims, wherein the gate driver is monolithically integrated in a single chip.

In a further example, a system comprises:
a half-bridge arrangement comprising a high side switch and a low side switch, and
a gate driver configured to drive the half-bridge arrangement. The gate driver comprises:
   a low voltage control logic configured to:
      receive a high side control signal, a low side control signal and a timing control signal;
      generate an internal pulsed high side control signal based on the high side control signal and the timing control signal; and
      generate a low side support function activation signal based on the low side control signal and the timing control signal;
   a high side switch control circuit coupled to the low voltage control logic and coupled to a control terminal of the high side switch and configured to control the high side switch based on the internal pulsed high side control signal, the high side switch control circuit comprising a high side support function circuit, wherein the high side support function circuit is configured to be enabled based on a first pulse of the internal pulsed high side control signal and to be activated based on a second pulse of the internal pulsed high side pulsed control signal; and
   a low side switch control circuit coupled to the low voltage control logic and coupled to a control terminal of the low side switch and configured to control the low side switch based on the low side control signal, the low side switch control circuit comprising a low side support function circuit, wherein the low side support function circuit is configured to be activated based on the low side support function activation signal.

In a further example, a gate driver system comprises:
a timing control signal input terminal configured to receive a timing control signal;
a timing control signal distribution line connected to the timing control signal input terminal, and
a plurality of gate drivers, each gate driver configured to drive a corresponding high side switch. Each gate driver of the plurality comprises:
   a low voltage control logic configured to:
      receive a high side control signal and the timing control signal via the timing control signal distribution line; and
      generate an internal pulsed high side control signal based on the high side control signal and the timing control signal; and
   a high side switch control circuit coupled to the low voltage control logic and configured to control the corresponding high side switch based on the internal pulsed high side control signal, the high side switch control circuit comprising a high side support function circuit, wherein the high side support function circuit is configured to be enabled based on a first pulse of the internal pulsed high side control signal and to be activated based on a second pulse of the internal high side pulsed control signal.

An example method for driving a high side switch comprises:
receiving a high side control signal and a timing control signal;
generating an internal pulsed high side control signal based on the high side control signal and the timing control signal;
controlling the high side switch based on the internal pulsed high side control signal;
enabling a high side support function based on a first pulse of the internal pulsed high side control signal; and
activating the high side support function based on a second pulse of the internal pulsed high side control signal.

In an example, the method further comprises:
generating the first pulse of the internal pulsed high side control signal based on a leading edge of the high side control signal;
generating the second pulse of the internal pulsed high side control signal by comparing a high side ramp-up signal and the timing control signal, the high side ramp-up signal having a non-zero signal slope upon reception of the leading edge of the high side control signal.

In a further example an example gate driver is configured to drive a half-bridge comprising a high side switch and a low side switch, comprises a low-voltage control logic configured to receive a high side control signal, a low side control signal and a common protection function blanking control signal, generate an internal pulsed high side control signal based on the high side control signal and the common protection function blanking control signal and generate a low side protection function activation signal based on the low side control signal and the common protection function blanking control signal, a high side switch control circuit coupled to the low-voltage control logic and configured to control the high side switch based on the internal pulsed high side control signal, the high side switch control circuit comprising a high side protection function circuit, wherein the high side protection function circuit is configured to be enabled based on a first pulse of the internal pulsed high side control signal and to be activated based on a second pulse of the internal pulsed high side control signal and a low side switch control circuit coupled to the low-voltage control logic and configured to control the low side switch based on the low side control signal, the low side switch control circuit comprising a low side protection function circuit, wherein the low side protection function circuit is configured to be activated based on the protection function activation signal.

The example gate driver may further comprise an insulation barrier between the low voltage control logic and the high side switch control circuit configured to electrically isolate the low voltage control logic from the high side switch control circuit and a high side signal forwarding circuit coupled between the low-voltage control logic and the high side switch control circuit, wherein the high side signal forwarding circuit may be configured to provide the internal pulsed high side control signal from the low-voltage control circuit to the high side switch control circuit across the insulation barrier.

In the example gate driver, the signal forwarding circuit may be one of a level shift circuit, a coreless transformer, an optocoupler and a solid state relay.

In the example gate driver, the low voltage control logic may be further configured to generate the first pulse of the internal pulsed high side control signal based on a leading edge of the high side control signal and generate the second pulse of the internal pulsed high side control signal by comparing a high side ramp-up signal and the common protection function blanking control signal, the high side ramp-up signal having a non-zero signal slope upon reception of the leading edge of the high side control signal.

In the example gate driver, the low voltage control logic may comprise a first high side edge triggered pulse generator configured to generate the first pulse of the internal pulsed high side control signal based on the leading edge of the high side control signal; and a high side protection function activation signal circuit configured to generate the second pulse of the internal pulsed high side control signal, comprising a high side leading edge triggered ramp-up circuit, the high side leading edge triggered ramp-up circuit being configured to provide the high side ramp-up signal responsive to the leading edge of the high side control signal, a high side ramp-up signal comparator configured to compare the high side ramp-up signal with the common protection function blanking control signal and to output a high side comparison signal based on the comparison and a second high side edge triggered pulse generator configured to generate the second pulse of the internal pulsed high side control signal based on a leading edge of the high side comparison signal.

In the example gate driver, the low-voltage control logic may further be configured to generate a high side switch control circuit reset signal configured to reset the high side switch control circuit.

In the example gate driver, the first high side edge triggered pulse generator may further be configured to generate the high side switch control circuit reset signal based on a trailing edge of the high side control signal.

In the example gate driver, the high side switch control circuit may further be configured to turn-on the high side switch and enable the high side protection function circuit based on latching the first pulse of the internal pulsed high side control signal and activate the high side protection function circuit based on latching the second pulse of the internal pulsed high side control signal.

In the example gate driver, the high side switch control circuit may further be configured to turn-off the high side switch and disable the high side protection function circuit based on unlatching the first pulse of the internal pulsed high side control signal and the second pulse of the internal pulsed high side control signal responsive to the high side switch control circuit reset signal.

In the example gate driver, the high side switch control circuit may further comprise a high side switch control flip-flop having a set input and a reset input and configured to receive the internal pulsed high side control signal at the set input and to receive the high side switch control circuit reset signal at the reset input and a high side protection function flip-flop having a set input, a reset input and an enable input and configured to receive the internal pulsed high side control signal at the set input, the high side switch control circuit reset signal at the reset input and an output of the high side switch control flip-flop at the enable input.

In the example gate driver, the high side protection function circuit may be configured to detect a desaturation of the high side switch and to turn off the high side switch based on the detected desaturation, and the low side protection function circuit may be configured to detect a desaturation of the low side switch and to turn off the low side switch based on the detected desaturation.

In the example gate driver, the low voltage control logic may further configured to generate the low side protection function activation signal by comparing a low side ramp-up signal and the common protection function blanking control signal, the low side ramp-up signal having a non-zero signal slope upon reception of a leading edge of the low side control signal.

In the example gate driver, the low voltage control logic may further comprise a low side protection function activation signal circuit configured to generate the low side protection function activation signal, comprising a low side leading edge triggered ramp-up circuit, the low side leading edge ramp-up circuit being configured to provide the low side ramp-up signal responsive to the leading edge of the low side control signal and a low side ramp-up signal comparator configured to compare the low side ramp-up signal with the common protection function blanking control signal and to output the low side protection function activation signal based on the comparison.

In an example, a method for driving a half-bridge comprising a high side switch and a low side switch, comprises receiving a high side control signal, a low side control signal and a common protection function blanking control signal, generating an internal pulsed high side control signal based on the high side control signal and the common protection function blanking control signal, generating a low side protection function activation signal based on the low side control signal and the common protection function blanking control signal, controlling the high side switch based on the internal pulsed high side control signal, enabling a high side protection function circuit based on a first pulse of the internal pulsed high side control signal, activating the high side protection function based on a second pulse of the internal pulsed high side control signal, controlling the low side switch based on the low side control signal and activating the low side protection function based on the low side protection function activation signal.

The example method may further comprise generating the first pulse of the internal pulsed high side control signal based on a leading edge of the high side control signal, and generating the second pulse of the internal pulsed high side control signal by comparing a high side ramp-up signal and the common protection function blanking control signal, the high side ramp-up signal having a non-zero signal slope upon reception of the leading edge of the high side control signal.

In the example method, controlling the high side switch may include turning on the high side switch based on latching the first pulse of the internal pulsed high side control signal, enabling the high side protection function circuit is based on latching the first pulse of the internal pulsed high side control signal and activating the high side protection function circuit is based on latching the second pulse of the internal pulsed high side control signal.

The example method may further comprise generating a high side switch control circuit reset signal configured to reset the high side switch control circuit and generating a low side switch control circuit reset signal configured to reset the low side switch control circuit.

In the example method, controlling the high side switch further may include turning off the high side switch based on unlatching the first pulse of the internal pulsed high side control signal, and the exemplary method may further comprise disabling the high side protection function circuit based on unlatching the first pulse of the internal pulsed high side control signal and the second pulse of the internal pulsed high side control signal responsive to the high side switch control circuit reset signal.

In the example method, generating the low side protection function activation signal may comprise comparing a low side ramp-up signal and the common protection function blanking control signal, the low side ramp-up signal having a non-zero signal slope upon reception of a leading edge of the low side control signal.

The preceding description has been provided to illustrate a gate driver and a method for driving a power switch with blanking time control. It should be understood that the description is in no way meant to limit the scope of the present disclosure to the precise embodiments discussed throughout the description. Rather, the person skilled in the art will be aware that the examples of the present disclosure may be combined, modified or condensed without departing from the scope of the present disclosure as defined by the following claims.

## Claims

1. A gate driver (100) configured to drive a high side switch (201), comprising:
a low voltage control logic (110) configured to:
receive a high side control signal (S_{HS}) and a timing control signal (S_{PBL}); and
generate an internal pulsed high side control signal (S_{HS,int}) based on the high side control signal (S_{HS}) and the timing control signal (S_{PBL});
a high side switch control circuit (130) coupled to the low voltage control logic (110) and configured to control the high side switch (201) based on the internal pulsed high side control signal (S_{HS,int}), the high side switch control circuit (130) comprising a high side support function circuit (132), wherein the high side support function circuit (132) is configured to be enabled based on a first pulse of the internal pulsed high side control signal (S_{HS,int}) and to be activated based on a second pulse of the internal pulsed high side control signal (S_{HS,int}).

2. The gate driver (100) of claim 1, further comprising:
an insulation barrier between the low voltage control logic (110) and the high side switch control circuit (130) configured to electrically isolate the low voltage control logic (110) from the high side switch control circuit (130); and
a high side signal forwarding circuit (120) coupled between the low voltage control logic (110) and the high side switch control circuit (130),
wherein the high side signal forwarding circuit (120) is configured to provide the internal pulsed high side control signal (S_{HS,int}) from the low voltage control logic (110) to the high side switch control circuit (130) across the insulation barrier.

3. The gate driver (100) of any one of the preceding claims, wherein the signal forwarding circuit (120) is one of a level shift circuit, a coreless transformer, an optocoupler and a solid state relay.

4. The gate driver (100) of any one of the preceding claims, wherein the low voltage control logic (110) is further configured to:
generate the first pulse of the internal pulsed high side control signal (S_{HS,int}) based on a leading edge of the high side control signal (S_{HS}); and
generate the second pulse of the internal pulsed high side control signal (S_{HS,int}) by comparing a high side ramp-up signal (S_{HS,ramp}) and the timing control signal (S_{PBL}), the high side ramp-up signal (S_{HS,ramp}) having a non-zero signal slope upon reception of the leading edge of the high side control signal (S_{HS}).

5. The gate driver (100) of claim 4, wherein the low voltage control logic (110) comprises:
a first high side edge triggered pulse generator (113₁) configured to generate the first pulse of the internal pulsed high side control signal (S_{HS,int}) based on the leading edge of the high side control signal (S_{HS}); and
a high side support function activation signal circuit configured to generate the second pulse of the internal pulsed high side control signal (S_{HS,int}), comprising:
a high side leading edge triggered ramp-up circuit (111₁), the high side leading edge triggered ramp-up circuit (111₁) being configured to provide the high side ramp-up signal (S_{HS,ramp}) responsive to the leading edge of the high side control signal (S_{HS});
a high side ramp-up signal comparator (112₁) configured to compare the high side ramp-up signal (S_{HS,ramp}) with the timing control signal (S_{PBL}) and to output a high side comparison signal (S_{HS,comp}) based on the comparison; and
a second high side edge triggered pulse generator (113₂) configured to generate the second pulse of the internal pulsed high side control signal (S_{HS,int}) based on a leading edge of the high side comparison signal(S_{HS}).

6. The gate driver (100) of any one of the preceding claims, wherein the low voltage control logic (110) is further configured to generate a high side switch control circuit reset signal (S_{HS,res}) configured to reset the high side switch control circuit (130).

7. The gate driver (100) of claims 5 and 6, wherein the first high side edge triggered pulse generator (113₁) is further configured to generate the high side switch control circuit reset signal (S_{HS,res}) based on a trailing edge of the high side control signal (S_{HS}).

8. The gate driver (100) of any one of the preceding claims, wherein the high side switch control circuit (130) is further configured to:
turn-on the high side switch (201) and enable the high side support function circuit (130) based on latching the first pulse of the internal pulsed high side control signal (S_{HS,int}); and
activate the high side support function circuit (132) based on latching the second pulse of the internal pulsed high side control signal (S_{HS,int}).

9. The gate driver (100) of claims 8 and any one of claims 6 and 7, wherein the high side switch control circuit (130) is further configured to:
turn-off the high side switch (201) and disable the high side support function circuit (132) based on unlatching the first pulse of the internal pulsed high side control signal (S_{HS,int}) and the second pulse of the internal pulsed high side control signal (S_{HS,int}) responsive to the high side switch control circuit reset signal (S_{HS,res}).

10. The gate driver (100) of any one of claim 8 and 9, wherein the high side switch control circuit (130) further comprises:
a high side switch control flip-flop (134) having a set input and a reset input and configured to receive the internal pulsed high side control signal (S_{HS,int}) at the set input and to receive the high side switch control circuit reset signal (S_{HS,res}) at the reset input; and
a high side support function flip-flop (131) having a set input, a reset input and an enable input and configured to receive the internal pulsed high side control signal (S_{HS,int}) at the set input, the high side switch control circuit reset signal (S_{HS,res}) at the reset input and an output of the high side switch control flip-flop (134) at the enable input.

11. The gate driver (100) of any one of the preceding claims, wherein:
the high side support function circuit (132) is configured to detect a desaturation of the high side switch (201) and to turn off the high side switch (201) based on the detected desaturation.

12. The gate driver (100) of any one of the preceding claims, further configured to drive a half-bridge (200) comprising the high side switch and a low side switch, wherein the low voltage control logic is further configured to:
receive a low side control signal (Sls); and
generate a low side support function activation signal (SLS,PA) based on the low side control signal (SLS) and the timing control signal (SPBL);
and the gate driver (100) further comprises:
a low side switch control circuit (150) coupled to the low voltage control logic (110) and configured to control the low side switch (202) based on the low side control signal (SLS), the low side switch control circuit (150) comprising a low side support function circuit (152), wherein the low side support function circuit (152) is configured to be activated based on the low side support function activation signal (SLS,PA).

13. A system, comprising:
a half-bridge arrangement comprising a high side switch and a low side switch, and
a gate driver configured to drive the half-bridge arrangement, comprising:
a low voltage control logic (110) configured to:
receive a high side control signal (S_{HS}), a low side control signal (S_{LS}) and a timing control signal (S_{PBL});
generate an internal pulsed high side control signal (S_{HS,int}) based on the high side control signal (S_{HS}) and the timing control signal (S_{PBL}); and
generate a low side support function activation signal (S_{LS,PA}) based on the low side control signal (S_{LS}) and the timing control signal (S_{PBL});
a high side switch control circuit (130) coupled to the low voltage control logic (110) and coupled to a control terminal of the high side switch and configured to control the high side switch (201) based on the internal pulsed high side control signal (S_{HS,int}), the high side switch control circuit (130) comprising a high side support function circuit (132), wherein the high side support function circuit (132) is configured to be enabled based on a first pulse of the internal pulsed high side control signal (S_{HS,int}) and to be activated based on a second pulse of the internal pulsed high side control signal (S_{HS,int}); and
a low side switch control circuit (150) coupled to the low voltage control logic (110) and coupled to a control terminal of the low side switch and configured to control the low side switch (202) based on the low side control signal (S_{LS}), the low side switch control circuit (150) comprising a low side support function circuit (152), wherein the low side support function circuit (152) is configured to be activated based on the low side support function activation signal (S_{LS,PA}).

14. A gate driver system (400), comprising:
a timing control signal input terminal configured to receive a timing control signal;
a timing control signal distribution line (401) connected to the timing control signal input terminal, and
a plurality of gate drivers (100), each gate driver configured to drive a corresponding high side switch, each gate driver of the plurality comprising:
a low voltage control logic (110) configured to:
receive a corresponding high side control signal (S_{HS}) and the timing control signal (S_{PBL}) via the timing control signal distribution line; and
generate an internal pulsed high side control signal (S_{HS,int}) based on the high side control signal (S_{HS}) and the timing control signal (S_{PBL}); and
a high side switch control circuit (130) coupled to the low voltage control logic (110) and configured to control the corresponding high side switch (201) based on the internal pulsed high side control signal (S_{HS,int}), the high side switch control circuit (130) comprising a high side support function circuit (132), wherein the high side support function circuit (132) is configured to be enabled based on a first pulse of the internal pulsed high side control signal (S_{HS,int}) and to be activated based on a second pulse of the internal high side pulsed control signal (S_{HS,int}).

15. A method (300) for driving a high side switch (201), comprising:
receiving (301) a high side control signal (S_{HS}) and a timing control signal (SPBL);
generating (302) an internal pulsed high side control signal (S_{HS,int}) based on the high side control signal (S_{HS}) and the timing control signal (S_{PBL});
controlling (304) the high side switch (201) based on the internal pulsed high side control signal (S_{HS,int});
enabling (305) a high side support function (132) based on a first pulse of the internal pulsed high side control signal (S_{HS,int}); and
activating (306) the high side control function (132) based on a second pulse of the internal pulsed high side control signal (S_{HS,int}).
